(19) Europäisches Patentamt
European Patent Office
Office européen des brevets

(11) **EP 1 306 795 A1**

## (12) DEMANDE DE BREVET EUROPEEN

(43) Date de publication:
**02.05.2003 Bulletin 2003/18**

(51) Int Cl.⁷: **G06K 9/00**

(21) Numéro de dépôt: **02354161.8**

(22) Date de dépôt: **16.10.2002**

(84) Etats contractants désignés:
**AT BE BG CH CY CZ DE DK EE ES FI FR GB GR
IE IT LI LU MC NL PT SE SK TR**
Etats d'extension désignés:
**AL LT LV MK RO SI**

(30) Priorité: **19.10.2001 FR 0113519**

(71) Demandeur: **STMicroelectronics S.A.
92120 Montrouge (FR)**

(72) Inventeur: **Tisse, Christel-Loic
13380 Plan de Cuques (FR)**

(74) Mandataire: **de Beaumont, Michel
1, rue Champollion
38000 Grenoble (FR)**

(54) **Filtre bidimensionnel non-déphaseur**

(57)     L'invention concerne un filtre passe-bande ayant au moins une bande passante, réel, bidimensionnel, orienté selon l'axe des phases et résultant du produit de deux fenêtres de Hamming unidimensionnelles identiques, la fonction de transfert de chacune de ces fenêtres étant :

$$X_i(f) = \alpha_i + (1 - \alpha_i)\cos\frac{\pi(f - fq_i)}{f0_i}, \text{ où}$$

f est une fréquence courante ;
$\alpha_i$ est un nombre réel, compris entre 0 et 1 exclus ;
$fq_i$ est une fréquence centrale de la bande passante ; et
$f0_i$ définit la moitié de la bande passante centrée sur $fq_i$.

Fig 2

**Description**

La présente invention concerne de façon générale le traitement numérique. Plus particulièrement, la présente invention concerne le filtrage dans le domaine fréquentiel de données numériques.

Lors du traitement de données numériques dans le domaine fréquentiel, résultant par exemple de l'application d'une transformée de Fourier à des données spatio-temporelles, on peut être amené, pour extraire des informations utiles, à appliquer des filtres à plusieurs bandes passantes. Ces informations utiles sont, par exemple, destinées à permettre un codage selon au moins deux types de données, par exemple trois : phase, module et fréquence. L'invention sera décrite par la suite en relation avec un exemple d'application au traitement d'une image numérique. Elle s'applique plus généralement à tout type de données numériques. Dans l'exemple, on considère plus particulièrement dans la présente description que les données à coder varient (présentent une information que l'on souhaite exploiter) selon une seule direction d'une image numérique, par exemple selon l'axe des lignes horizontales. Une telle image peut elle-même résulter d'un traitement antérieur.

La présente invention vise à proposer un filtre numérique bidimensionnel et applicable dans le domaine fréquentiel.

La présente invention vise également à proposer un tel filtre qui soit non-déphaseur donc réel, c'est-à-dire dont la partie imaginaire soit nulle.

La présente invention vise également à proposer un tel filtre qui est orienté dans le sens des phases.

La présente invention vise également à proposer un tel filtre dont l'expression analytique comporte des opérations mathématiques simples.

Pour atteindre ces objets et d'autres, la présente invention prévoit un filtre passe-bande à au moins une bande passante, réel, bidimensionnel, orienté selon l'axe des phases et résultant du produit de deux fenêtres de Hamming unidimensionnelles identiques, la fonction de transfert de chacune de ces fenêtres étant :

$$X_i(f) = \alpha_i + (1 - \alpha_i)\cos\frac{\pi(f - fq_i)}{f0_i},$$

où
f est une fréquence courante ;
$\alpha_i$ est un nombre réel, compris entre 0 et 1 exclus ;
$fq_i$ est une fréquence centrale de la bande passante ; et
$f0_i$ définit la moitié de la bande passante centrée sur $fq_i$.

Selon un mode de réalisation de la présente invention, les fenêtres sont des fenêtres de Hanning, pour lesquelles le nombre réel $\alpha_i$ vaut 0,54.

Selon un mode de réalisation de la présente invention, le filtre présente une bande passante d'une largeur d'une octave.

Selon un mode de réalisation de la présente invention, la bande passante de chacune des fenêtres de Hamming est définie par :

$$f0_i = \frac{\pi}{3\arccos\left(\dfrac{\dfrac{1}{2}-\alpha_i}{1-\alpha_i}\right)}fq_i,$$

où arcos désigne la fonction inverse de cosinus.

La présente invention prévoit également un filtre passe-bande à plusieurs bandes passantes, dont chaque bande passante est conforme à l'un quelconque des modes de réalisation précédents.

Selon un mode de réalisation de la présente invention, un tel filtre est appliqué à la détection d'une texture d'un élément annulaire, la texture étant un ensemble d'informations variant essentiellement selon la position angulaire dans des cercles concentriques.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 illustre, schématiquement et sous forme de blocs, un mode de réalisation d'un filtre selon la présente invention ; et

la figure 2 illustre la fonction de transfert d'une composante d'un filtre selon la présente invention.

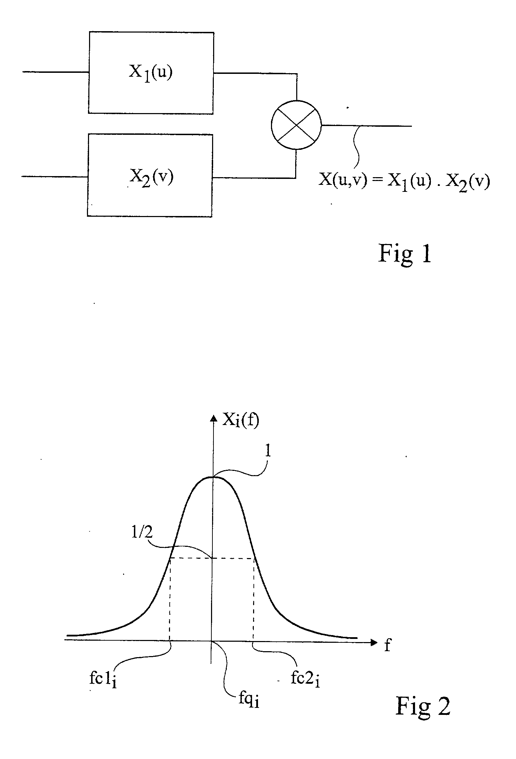

Comme l'illustre la figure 1, un filtre passe-bande bidimensionnel selon la présente invention est le produit de deux filtres passe-bande identiques à une dimension, chacun constituant une fenêtre de Hamming de fonction de transfert respective $X_1(u)$ et $X_2(v)$. La fonction de transfert $X(u,v)$ du filtre bidimensionnel est donc : $X(u,v)=X_1(u).X_2(v)$.

La figure 2 illustre la fonction de transfert $Xi(f)$ d'une fenêtre de Hamming dans le domaine fréquentiel. Cette fonction de transfert a pour expression analytique :

$$X_i(f) = \alpha_i + (1 - \alpha_i)\cos\frac{\pi(f - fq_i)}{f0_i},$$

où

$f$ est la fréquence courante (axe des abscisses) ;

$\alpha_i$ est un nombre réel, généralement appelé coefficient de Hamming, compris entre 0 et 1 exclus ;

$fq_i$ est la fréquence centrale du filtre passe-bande, c'est-à-dire la valeur de fréquence pour laquelle la réponse du filtre passe-bande est maximale ($X_i(fq_i)=1$) ; et

$f0_i$ définit la moitié de la bande passante centrée sur la fréquence $fq_i$ délimitée par des fréquences $fc1_i$ et $fc2_i$ pour lesquelles la réponse du filtre vaut la moitié de la valeur maximale ($X_i(fc1_i)=X_i(fc2_i)=1/2$). Les fréquences $fc1_i$ et $fc2_i$ délimitent l'étalement spectral à -3 dB par rapport à la fréquence centrale $fq_i$ et sont fixées par la valeur $f0_i$.

Selon un mode de réalisation particulier de la présente invention, le filtre présente une bande passante d'une largeur d'une octave.

Alors, avec les notations précédentes, la bande passante du filtre d'une octave est obtenue si la valeur $f0_i$ est égale à :

$$f0_i = \frac{\pi}{3\arccos\left(\dfrac{\dfrac{1}{2}-\alpha_i}{1-\alpha_i}\right)}fq_i,$$

où arcos désigne la fonction inverse de cosinus.

De préférence, les fenêtres de Hamming sont des fenêtres dites de Hanning pour lesquelles le coefficient $\alpha_i$ vaut 0,54.

Un exemple d'application d'un tel filtre est d'isoler les composantes spectrales d'une image numérique selon une direction donnée.

Par exemple, l'iris d'un oeil se caractérise par des informations de texture qui varient selon des cercles compris entre la pupille et la limite entre l'iris et la cornée. Le codage des informations d'un iris s'effectue alors de la façon suivante.

Tout d'abord, les informations circulaires sont dépliées en informations linéaires, par exemple horizontales, par une conversion polaire à angle constant. Ensuite, on applique à l'image résultant de la conversion une transformée de Fourier. Les valeurs discrètes obtenues dans le domaine fréquentiel sont alors soumises à divers procédés numériques connus pour permettre un codage ultérieur, par exemple exposés dans les brevets américains N° 5 291 560 et 5 572 596 ou dans la demande internationale 00/62239.

Appliquer le filtre selon la présente invention aux valeurs discrètes résultant de la transformée de Fourier présente de nombreux avantages en termes de simplicité et fiabilité par rapport aux procédés connus. En effet, comme cela ressort de la description précédente, les opérations mathématiques les plus compliquées d'un traitement par le filtre selon la présente invention sont les calculs d'un cosinus ainsi que de l'inverse d'un cosinus pour définir la bande passante à partir de la fréquence centrale $fq_i$. Les procédés connus utilisent des fonctions mathématiques, notamment exponentielles, plus compliquées qui demandent plus de temps et d'espace logiciel. En outre, le filtre selon l'invention étant non déphaseur, il permet d'extraire très rapidement les données de phase par des procédés de démodulation relativement simples. En particulier, il permet l'application d'une transformée dite de Hilbert qui permet d'obtenir simultanément toutes les données de codage. Le code en module, phase et fréquence est ensuite reporté dans le domaine spatio-temporel en appliquant une transformée de Fourier inverse.

Le recours à un filtre selon la présente invention permet en outre d'accroître la fiabilité du codage effectué. En effet, la succession d'opérations longues et/ou complexes des procédés connus étant remplacée par des calculs simples et rapides, moins d'approximations sont effectuées et/ou il est possible pendant le même temps de traitement de coder plus de données de l'image initiale.

Dans l'application décrite précédemment de codage d'un iris, le code en module, phase et fréquence obtenu permet une reconnaissance iridienne utilisable comme paramètre de reconnaissance pour identifier un individu. Un exemple d'application est le contrôle d'accès : accès à un site physique, tel qu'une commande.d'ouverture d'une porte par code, ou par carte d'accès ; accès à un compte bancaire habituellement protégé par un mot de passe ; accès à un dispositif quelconque tel qu'un ordinateur ou un téléphone portable habituellement protégé par un code à saisir. Un tel dispositif peut également remplacer l'identification par empreintes digitales ou autre identification biométrique.

De préférence, on utilise lors d'un tel traitement un filtre à plusieurs bandes passantes comportant trois fréquences centrales réparties de façon à être séparées d'une octave, par exemple, 7, 14 et 28 cycles par image. Un tel filtre à plusieurs bandes passantes est constitué de la somme de trois filtres passe-bande selon la présente invention.

Bien entendu, la présente invention est susceptible de diverses variantes et modifications qui apparaîtront à l'homme de l'art. En particulier, un filtre selon la présente invention s'applique dans d'autres domaines que la reconnaissance d'iris. Par exemple, il peut être appliqué lors de toute détection d'une texture d'un élément annulaire, la texture étant caractérisée par des informations à coder qui varient essentiellement selon la position angulaire dans des cercles concentriques.

Plus généralement, le filtre selon la présente invention est utilisable dans toute application requérant un filtre passe-bande(s) non-déphaseur, bidimensionnel et orienté selon l'axe des phases.

**Revendications**

1. Filtre passe-bande dans le domaine fréquentiel ayant au moins une bande passante, **caractérisé en ce qu'**il est réel, bidimensionnel, orienté selon l'axe des phases et résulte du produit de deux fenêtres de Hamming unidimensionnelles identiques, la fonction de transfert de chacune de ces fenêtres étant :

$$X_i(f) = \alpha_i + (1 - \alpha_i)\cos\frac{\pi(f - fq_i)}{f0_i},$$

où

f est une fréquence courante ;

$\alpha_i$ est un nombre réel, compris entre 0 et 1 exclus ;

$fq_i$ est une fréquence centrale de la bande passante ; et

$f0_i$ définit la moitié de la bande passante centrée sur $fq_i$.

2. Filtre selon la revendication 1, **caractérisé en ce que** les fenêtres sont des fenêtres de Hanning, pour lesquelles le nombre réel $\alpha_i$ vaut 0,54.

3. Filtre selon la revendication 1 ou 2, **caractérisé en ce qu'**il présente une bande passante d'une largeur d'une octave.

4. Filtre selon la revendication 3, **caractérisé en ce que** la bande passante de chacune des fenêtres de Hamming est définie par :

$$f0_i = \frac{\pi}{3\arccos\left(\dfrac{\dfrac{1}{2} - \alpha_i}{1 - \alpha_i}\right)} fq_i,$$

où arcos désigne la fonction inverse de cosinus.

**5.** Filtre passe-bande à plusieurs bandes passantes, **caractérisé en ce que** chaque bande passante est conforme à l'une quelconque des revendications 1 à 4.

**6.** Filtre selon l'une quelconque des revendications 1 à 5, **caractérisé en ce qu'**il est appliqué à la détection d'une texture d'un élément annulaire, la texture étant un ensemble d'informations variant essentiellement selon la position angulaire dans des cercles concentriques.

$$X(u,v) = X_1(u) \cdot X_2(v)$$

Fig 1

Fig 2

**Office européen des brevets**

**RAPPORT DE RECHERCHE EUROPEENNE**

Numéro de la demande

EP 02 35 4161

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | "Windowing Method" MATLAB DOCUMENTATION - IMAGE PROCESSING TOOLBOX, [en ligne] 8 mars 2001 (2001-03-08), page 1 XP002205212 Extrait de l'Internet: <URL:http://www.mathworks.com/access/helpdesk/help/toolbox/images/linfill1.shtml> [extrait le 2002-07-09] * le document en entier * | 1-5 | G06K9/00 |
| A L | & "Wayback Machine : Searching Page" THE INTERNET ARCHIVE: BUILDING AN 'INTERNET LIBRARY', [en ligne] page 1 Extrait de l'Internet: <URL:http://web.archive.org/web/*/http://www.mathworks.com/access/helpdesk/help/toolbox/images/linfill1.shtml> [extrait le 2002-07-09] * Document cité pour déterminer la date de publication * * le document en entier * --- | 6 1-6 | |
| A | DAUGMAN J: "HIGH CONFIDENCE RECOGNITION OF PERSONS BY RAPID VIDEO ANALYSIS OF IRIS TEXTURE" ECOS. EUROPEAN CONVENTION ON SECURITY AND DETECTION, XX, XX, 16 mai 1995 (1995-05-16), pages 244-251, XP000671918 * page 247, colonne de gauche, dernier alinéa * --- -/-- | 6 | |

**DOMAINES TECHNIQUES RECHERCHES (Int.Cl.7)**

G06K

Le présent rapport a été établi pour toutes les revendications

| Lieu de la recherche | Date d'achèvement de la recherche | Examinateur |
|---|---|---|
| LA HAYE | 25 février 2003 | Granger, B |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**Office européen des brevets**

## RAPPORT DE RECHERCHE EUROPEENNE

Numéro de la demande

EP 02 35 4161

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | BINGHAM C. ET AL: "Modern Techniques of Power Spectrum Estimation" IEEE TRANS. ON AUDIO AND ELECTRONICS, [en ligne] vol. AU-15, no. 2, juin 1967 (1967-06), pages 55-66, XP002205211 Extrait de l'Internet: <URL:http://qss.stanford.edu/~godfrey/statistics/mtpse.pdf> [extrait le 2002-07-09] * page 57, colonne de droite, alinéas 5,6 * | 2-5 | |
| A | GRAHAM J R: "Windowing and the DFT" FOURIER TRANSFORMS & THE FREQUENCY DOMAIN, [en ligne] 22 février 2001 (2001-02-22), pages 1-3, XP002205213 Extrait de l'Internet: <URL:http://astron.berkeley.edu/~jrg/ngst/fft/window.html> [extrait le 2002-07-09] Paragraphe "Hanning / Hamming Window" | 1-5 | |
| L | & "Wayback Machine : Searching Page" THE INTERNET ARCHIVE: BUILDING AN 'INTERNET LIBRARY', [en ligne] page 1 Extrait de l'Internet: <URL:http://web.archive.org/web/*/http://astron.berkeley.edu/~jrg/ngst/fft/window.html> [extrait le 2002-07-09] * Document cité pour déterminer la date de publication * * le document en entier * | 1-5 | DOMAINES TECHNIQUES RECHERCHES (Int.Cl.7) |

Le présent rapport a été établi pour toutes les revendications

| Lieu de la recherche | Date d'achèvement de la recherche | Examinateur |
|---|---|---|
| LA HAYE | 25 février 2003 | Granger, B |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)